# EUROPEAN PATENT APPLICATION

(11) **EP 4 654 261 A1**
(43) Date of publication of application: **26.11.2025**
(21) Application number: 25168702.6
(22) Date of filing: 04.04.2025
(51) Int. Cl.: H01L 23/528, H01L 23/532, H01L 21/768, B82Y 10/00, C25D 3/38

(54) **BACKSIDE POWER DELIVERY USING CONDUCTIVE MATERIALS WITH PREFERENTIAL GRAIN ALIGNMENT**

(30) Priority: 23.05.2024 US 202418672220
(71) Applicant: INTEL Corporation, Santa Clara, CA 95054 (US)
(72) Inventor: BURK, Jonathan, Portland, 97229 (US); CHIDAMBARAM, Vivek, 545119 Sengkang (SG); GAUTAM, Madhav, Portland, 97229 (US); GATIMU, Alvin, Hillsboro, 97124 (US)
(74) Representative: HGF

(57) **Abstract**

Disclosed herein are IC structures with backside power delivery (BPD) using conductive materials with preferential grain alignment. An example IC structure may include a device layer including a plurality of transistors, the device layer having a first side and a second side opposite the first side; one or more backend layers at the first side of the device layer, the one or more backend layers including backend interconnects coupled to one or more of the plurality of transistors; and a BPD arrangement that includes one or more backside layers at the second side of the device layer, wherein the one or more backside layers include an insulator material, an opening in the insulator material, the opening lined with a liner material, and a conductive material within the opening lined with the liner material, wherein the conductive material has a preferential grain alignment.

## Description

### Background

For the past several decades, the scaling of features in integrated circuits has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for the ever-increasing capacity, however, is not without issue. The necessity to optimize fabrication and performance of each component becomes increasingly significant.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIGS. 1A-1C provide schematic illustrations of integrated circuit (IC) structures in which backside power delivery (BPD) arrangements that employ conductive materials with preferential grain alignment may be implemented, according to some embodiments of the present disclosure.
FIGS. 2A-2B illustrate example cross-sectional side view of IC structures with BPD arrangements that employ conductive materials with preferential grain alignment, according to some embodiments of the present disclosure.
FIGS. 3A-3C illustrate example cross-sectional side views of conductive materials with preferential grain alignment that may be used in a BPD arrangement, according to some embodiments of the present disclosure.
FIG. 4 is a flow diagram of a fabrication method for providing an IC structures with a BPD arrangement using conductive materials with preferential grain alignment, in accordance with some embodiments.
FIGS. 5A-5F provide cross-sectional side views at various stages in the fabrication of an example IC structure according to the method of FIG. 4, in accordance with some embodiments.
FIG. 6 illustrates top views of a wafer and dies that may include one or more IC structures with BPD using conductive materials with preferential grain alignment, according to some embodiments of the present disclosure.
FIG. 7 illustrates a cross-sectional side view of an IC device assembly that may include one or more IC structures with BPD using conductive materials with preferential grain alignment, according to some embodiments of the present disclosure.
FIG. 8 illustrates a block diagram of an example computing device that may include one or more IC structures with BPD using conductive materials with preferential grain alignment, according to some embodiments of the present disclosure.

### Detailed Description

The systems, methods and devices of this disclosure each have several innovative aspects, no single one of which is solely responsible for all of the desirable attributes disclosed herein. Details of one or more implementations of the subject matter described in this specification are set forth in the description below and the accompanying drawings.

For purposes of illustrating IC structures with BPD using conductive materials with preferential grain alignment, described herein, it might be useful to first understand phenomena that may come into play in certain IC arrangements. The following foundational information may be viewed as a basis from which the present disclosure may be properly explained. Such information is offered for purposes of explanation only and, accordingly, should not be construed in any way to limit the broad scope of the present disclosure and its potential applications.

Front-end-of-line (FEOL) and back-end-of-line (BEOL) are two distinct stages in semiconductor manufacturing (e.g., in advanced complementary metal-oxide-semiconductor (CMOS) processes), each playing an important role in the fabrication of IC structures (or, more generally, of semiconductor devices). These terms refer to the chronological order of processes involved in creating an IC structure. The FEOL processes occur at the front or early stages of semiconductor manufacturing, typically on the surface of a semiconductor (e.g., silicon) wafer. FEOL involves the fabrication of the active components of the semiconductor device, such as transistors and other active devices. The BEOL processes occur after the completion of the FEOL processes and may involve the entire wafer, including the areas where active components have been created during the FEOL stage. The BEOL involves providing the interconnection of the active devices of the FEOL and the creation of the final wiring and metal layers that connect the transistors and other components. The BEOL is typically focused on creating the metal interconnects that form the circuit paths.

Power delivery to active components of IC structures is not an easy task, especially as more and more components are built in multiple layers over a wafer. Conventionally, power delivery has been done from the front side, by routing power interconnects from the top of the IC structures down to the active devices of the FEOL. However, as more and more components are built in multiple layers on the front sides of wafers, frontside power delivery to these components becomes challenging. Therefore, BPD has been explored recently as an alternative to frontside power delivery. BPD has several advantages over frontside power delivery, such as eliminating the need to share interconnect resources between signal and power lines on the front side and enabling long-term cost savings by eliminating the need for power delivery tracks from lower layer frontside interconnects. One of the challenges of BPD has been achieving as low resistance as possible for backside power interconnect arrangements.

Disclosed herein are IC structures with BPD arrangements that use conductive materials with preferential grain alignment. Such BPD arrangements may be used to assist power delivery to various components of IC structures, e.g., to transistors or other components of the FEOL layers. Embodiments of the present disclosure are based on recognition that one of the factors contributing to an increased resistance in backside power interconnect arrangements is the necessity to use a liner of one or more materials that can reduce or eliminate electromigration of conductive materials (e.g., copper) into semiconductor materials of a substrate (e.g., silicon). Such materials are referred to herein as "barrier materials." Reducing the thickness of barrier material liners would advantageously allow reducing the associated resistance that increases the overall resistance of backside power interconnect arrangements, but, in conventional implementations, this comes at a cost of increased electromigration of conductive materials. Embodiments of the present disclosure are further based on recognition that conventional implementations use polycrystalline conductive materials (i.e., conductive materials that have grains arranged randomly in different orientations, with no preferential alignment), e.g., polycrystalline copper, that are deposited into opening lined with barrier materials and that such materials have a particularly high affinity to electromigration. On the other hand, inventors of the present disclosure realized that conductive materials that have preferential grain alignment have a reduced affinity to electromigration. For example, in one aspect, an example IC structure may include a device layer including a plurality of transistors, the device layer having a first side and a second side opposite the first side; one or more backend layers at the first side of the device layer, the one or more backend layers including backend interconnects coupled to one or more of the plurality of transistors; and a BPD arrangement that includes one or more backside layers at the second side of the device layer, wherein the one or more backside layers include an insulator material, an opening in the insulator material, the opening lined with a liner material (e.g., a barrier material), and a conductive material within the opening lined with the liner material, wherein the conductive material has a preferential grain alignment. For example, in some embodiments, majority of grains (e.g., at least about 50% of the grains) of the conductive material may be oriented/aligned substantially along a single direction. Because of the reduced affinity to electromigration using conductive materials with preferential grain alignment within the openings lined with barrier materials in backside power interconnect arrangements may allow reducing the thickness of the barrier material liners and, hence, reduce the overall resistance of the arrangements, while preserving adequate performance. Furthermore, using conductive materials with preferential grain alignment for interconnect structures used for power delivery may enable one or more of the following advantages: an improved resistance to plastic deformation, improved thermally stability, enhanced mechanical properties, improved thermal diffusivity, mitigated grain boundary scattering, enhanced backside interconnect's reliability, and ability to achieve significant resistance decrease without significant changes to the existing fabrication processes.

Providing power delivery using conductive materials with preferential grain alignment from the back side, as opposed to the front side, may increase integration density on the front side of the IC structures (e.g., the freed-up space on the front side can be utilized for additional active components, enabling higher levels of integration), reduce interference and improve signal integrity on the front side, contribute to better electromagnetic compatibility (EMC) by reducing the potential for interference between power delivery and signal lines, improve thermal management (e.g., potentially reducing the impact of localized heating on the device's performance), and help realize full benefits of three-dimensional (3D) IC integration where multiple layers of active devices are stacked on top of each other. Other technical effects will be evident from various embodiments described here. However, BPD arrangements that use conductive materials with preferential grain alignment, described herein, may also be used for power delivery from the front side. Furthermore, although conductive materials with preferential grain alignment are described herein with reference to delivery of power, BPD arrangements that use conductive materials with preferential grain alignment, described herein, may also be used for providing signals, e.g., input/output (I/O) signals from the back side and/or from the front side.

In the following detailed description, various aspects of the illustrative implementations may be described using terms commonly employed by those skilled in the art to convey the substance of their work to others skilled in the art. For example, the term "connected" means a direct electrical or magnetic connection between the things that are connected, without any intermediary devices, while the term "coupled" means either a direct electrical or magnetic connection between the things that are connected, or an indirect connection through one or more passive or active intermediary devices. The term "circuit" means one or more passive and/or active components that are arranged to cooperate with one another to provide a desired function. If used, the terms "oxide," "carbide," "nitride," etc. refer to compounds containing, respectively, oxygen, carbon, nitrogen, etc., the term "high-k dielectric" refers to a material having a higher dielectric constant (k) than silicon oxide, while the term "low-k dielectric" refers to a material having a lower k than silicon oxide. The terms "substantially," "close," "approximately," "near," and "about," generally refer to being within +/-20%, e.g., within +/- 5% or within +/- 2%, of a target value based on the context of a particular value as described herein or as known in the art. Similarly, terms indicating orientation of various elements, e.g., "coplanar," "perpendicular," "orthogonal," "parallel," or any other angle between the elements, generally refer to being within +/- 20%, e.g., within +/- 5% or within +/- 2% of a target value based on the context of a particular value as described herein or as known in the art.

The terms "over," "under," "between," and "on" as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact (e.g., in direct physical contact) with that second layer. Similarly, unless explicitly stated otherwise, one feature disposed between two features may be in direct contact with the adjacent features or may have one or more intervening layers.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges. As used herein, the notation "A/B/C" means (A), (B), and/or (C).

Although certain elements may be referred to in the singular herein, such elements may include multiple sub-elements. For example, "an insulator material" may include one or more insulator materials. The term "insulating" and variations thereof (e.g., "insulative" or "insulator") means "electrically insulating," the term "conducting" and variations thereof (e.g., "conductive" or "conductor") means "electrically conducting," unless otherwise specified. For example, the term "insulator material" may refer to solid materials (and/or liquid materials that solidify after processing as described herein) that are substantially electrically non-conducting. They may include, as examples and not as limitations, organic polymers and plastics, and inorganic materials such as ionic crystals, porcelain, glass, silicon and alumina or a combination thereof. They may include dielectric materials, high polarizability materials, and/or piezoelectric materials. They may be transparent or opaque without departing from the scope of the present disclosure. With reference to optical signals and/or devices, components and elements that operate on or using optical signals, the term "conducting/conductive" can also mean "optically conducting/conductive."

The description may use the phrases "in an embodiment" or "in embodiments," which may each refer to one or more of the same or different embodiments. Furthermore, the terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner.

In the following detailed description, reference is made to the accompanying drawings that form a part hereof wherein like numerals designate like parts throughout, and in which is shown, by way of illustration, embodiments that may be practiced. It is to be understood that other embodiments may be utilized, and structural or logical changes may be made, without departing from the scope of the present disclosure. Therefore, the following detailed description is not to be taken in a limiting sense.

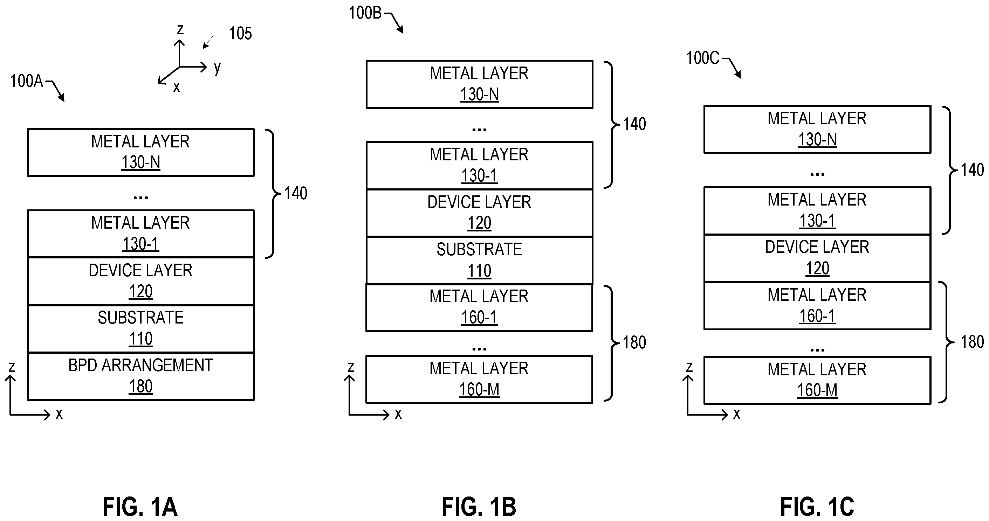

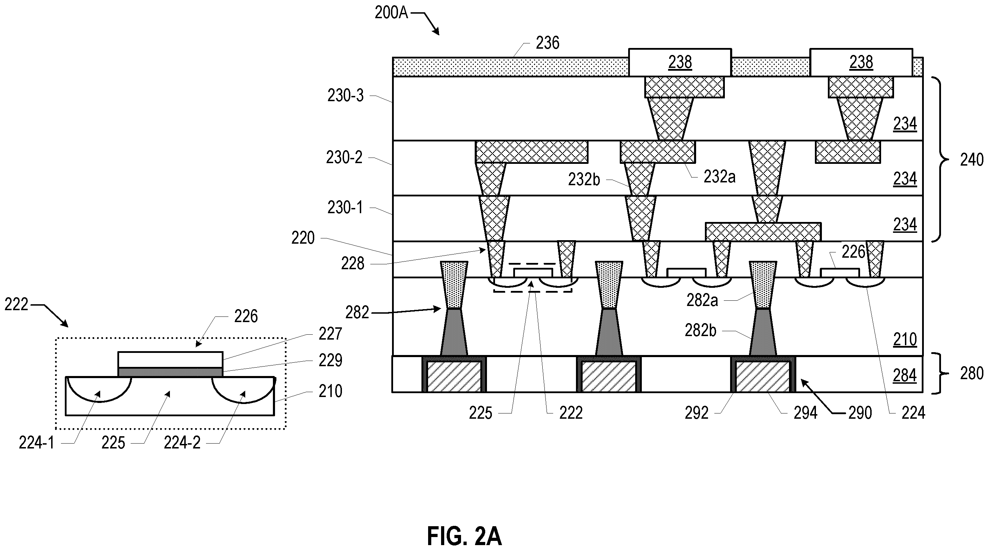

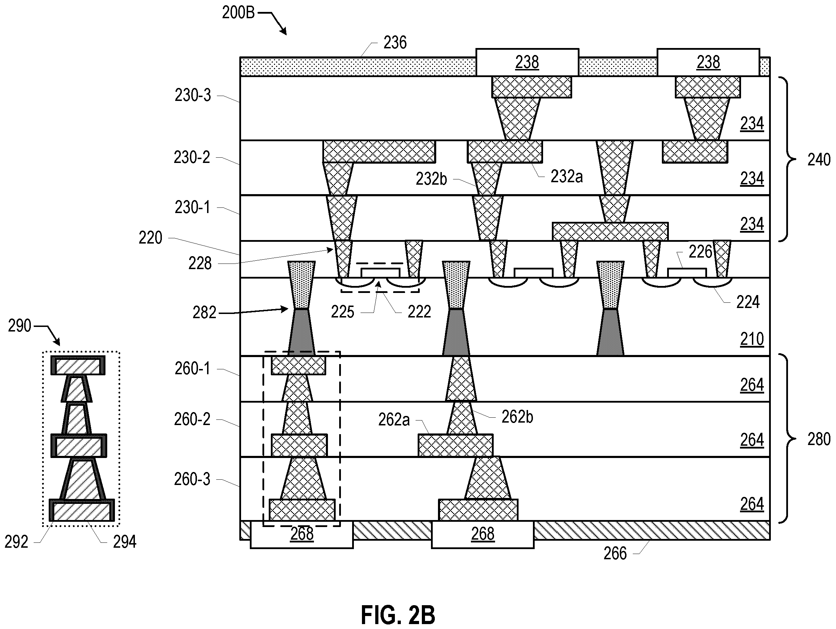

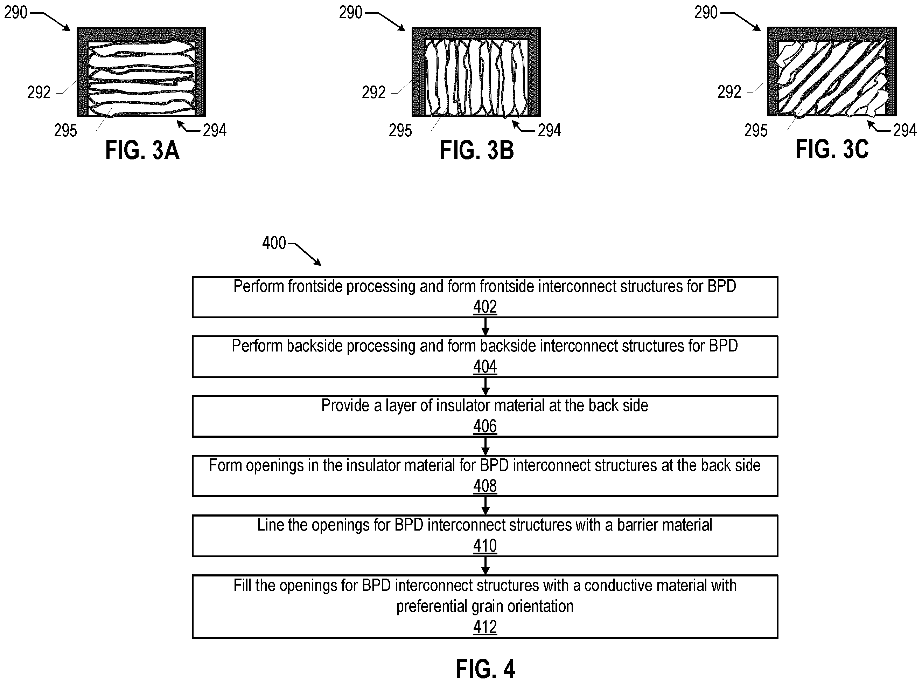

Any of the features discussed with reference to any of accompanying drawings herein may be combined with any other features to form IC structures with BPD arrangements that employ conductive materials with preferential grain alignment, as appropriate. A number of elements of the drawings are shared with others of the drawings; for ease of discussion, a description of these elements is not repeated, and these elements may take the form of any of the embodiments disclosed herein. If multiple instances of certain elements are illustrated, then, in some cases, to not clutter the drawings only some of these elements may be labeled with a reference sign and other ones of these elements are not labeled (e.g., although FIG. 2A illustrates three transistors 222, only one of them is labeled with a reference sign). However, in other cases, for ease of explanation, different instances of a given element in a single drawing may be referred to with numbers 1, 2, and so on, after a dash, while all of the instances of that element may be referred to without numbers after a dash (e.g., FIG. 2A illustrates three metal layers 230, labeled individually as metal layers 230-1, 230-2, and 230-3). For convenience, the phrase "FIG. 1" may be used to refer to the collection of drawings of FIGS. 1A-1C, the phrase "FIG. 2" may be used to refer to the collection of drawings of FIGS. 2A-2B, and the phrase "FIG. 3" may be used to refer to the collection of drawings of FIGS. 3A-3C. Similarly, the phrase "IC structures 100" may be used to refer to a collection of IC structures 100A-100C of FIGS. 1A-1C.

The drawings are not necessarily to scale. In the drawings, some schematic illustrations of example structures of various devices and assemblies described herein may be shown with precise right angles and straight lines, but it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of presence of IC structures with BPD arrangements that employ conductive materials with preferential grain alignment as described herein.

Various IC structures with BPD arrangements that employ conductive materials with preferential grain alignment as described herein may be implemented in, or associated with, one or more components associated with an IC or/and may be implemented between various such components. In various embodiments, components associated with an IC include, for example, transistors, diodes, power sources, resistors, capacitors, inductors, sensors, transceivers, receivers, antennas, etc. Components associated with an IC may include those that are mounted on IC or those connected to an IC. The IC may be either analog or digital and may be used in a number of applications, such as microprocessors, optoelectronics, logic blocks, audio amplifiers, etc., depending on the components associated with the IC. The IC may be employed as part of a chipset for executing one or more related functions in a computer.

FIG. 1A illustrates a cross-sectional view of an example IC structure 100A in which a BPD arrangement using conductive materials with preferential grain alignment may be implemented, according to some embodiments of the present disclosure. FIG. 1A illustrates an example coordinate system 105 with axes x-y-z so that the various planes illustrated in FIG. 1A and in some subsequent drawings may be described with reference to this coordinate system.

As shown in FIG. 1A, in general, the IC structure 100A may include a substrate 110, a device layer 120, and a plurality of metal layers 130, individually labeled as a metal layer 130-1 through metal layer 130-N, where N is an integer greater than 1. Together, the metal layers 130 may be referred to as a metallization stack 140. The illustration of FIG. 1A is intended to provide a general orientation and arrangement of various layers with respect to one another, and, unless specified otherwise in the present disclosure, includes embodiments of the IC structure 100A where portions of elements described with respect to one of the layers shown in FIG. 1A may extend into one or more, or be present in, other layers. Same applies to the subsequent drawings.

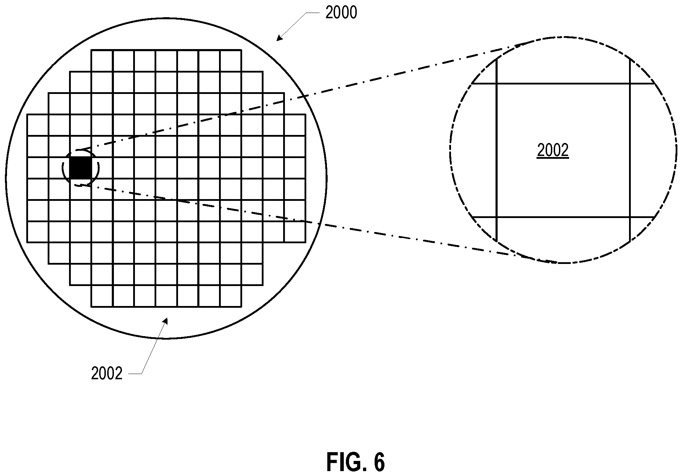

The substrate 110 may be any suitable support over which the device layer 120 and the metallization stack 140 may be provided. For example, the substrate 110 may be a die, a wafer, a chip, or any other suitable support structure. The substrate 110 may, e.g., be the wafer 2000 of FIG. 6, discussed below, and may be, or be included in, a die, e.g., the singulated die 2002 of FIG. 6, discussed below. The substrate 110 may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the substrate may be non-crystalline. In some embodiments, the substrate 110 may be a printed circuit board (PCB) substrate. Although a few examples of materials from which the substrate may be formed are described here, any material that may serve as a foundation upon which a semiconductor device implementing any of the BPD arrangements that employ conductive materials with preferential grain alignment as described herein may be built falls within the scope of the present disclosure.

The device layer 120 may include any combination of components (e.g., ICs) provided over the substrate 110. For example, in some embodiments, the device layer 120 may include various logic layers, circuits, and devices (e.g., logic transistors) to drive and control a logic IC. In some embodiments, the device layer 120 may include memory devices/circuits. The device layer 120 may also be referred to as a "FEOL layer" and the components of the device layer 120 (e.g., transistors) may be referred to as "frontend components."

Various layers of the metallization stack 140 may be, or include, BEOL layers, which may also be referred to as "backend layers." As used herein, the term "metal layer" may refer to a layer above a substrate 110 that includes electrically conductive interconnect structures (e.g., conductive lines and conductive vias) for providing electrical connectivity between different IC components, e.g., between different components of the device layer 120. Metal layers described herein may also be referred to as "metal layers" to indicate that these layers include electrically conductive interconnect structures which may, but does not have to, be metal. Various metal layers of the metallization stack 140 may be used to interconnect the various inputs and outputs of the active components (e.g., transistors) in the device layer 120. Generally speaking, each of the metal layers of the metallization stack 140 may include a conductive line (also sometimes referred to as a "trench," a "trace," or a "metal line") and/or a conductive via. Conductive lines of a metal layer are interconnects configured for transferring signals and power along electrically conductive (e.g., metal) structures extending in the x-y plane (e.g., in the x or y directions), while the conductive vias of a metal layer are configured for transferring signals and power through electrically conductive structures extending in the z-direction, e.g., to any of the adjacent metal layers above or below. Accordingly, conductive vias connect interconnect structures (e.g., conductive lines and/or conductive vias) of one metal layer to interconnect structures of an adjacent metal layer. While referred to as "metal" layers, various layers of the metallization stack 140 may include only certain patterns of conductive metals, e.g., copper, aluminum, tungsten, or cobalt, or metal alloys, or more generally, patterns of an electrically conductive material, formed in a medium of an insulator material such as an interlayer dielectric (ILD). The insulator medium may include any suitable ILD materials such as silicon oxide, carbon-doped silicon oxide, silicon carbide, silicon nitride, aluminum oxide, and/or silicon oxynitride.

The side of the substrate 110 on which the device layer 120 is provided is typically referred to as a "front side," and the other side of the substrate 110 is referred to as a "back side." Thus, the device layer 120 and the metal layers 130 are frontside layers. FIG. 1A further illustrates that a BPD (BPD) arrangement 180 may be implemented on the back side of the substrate 110. As shown in FIG. 1A, the substrate 110 may be between the device layer 120 on the front side and the BPD arrangement 180 on the back side, and the device layer 120 may be between the metallization stack 140 and the substrate 110 or the BPD arrangement 180.

FIG. 1B illustrates a cross-sectional view of an example IC structure 100B in which a BPD arrangement using conductive materials with preferential grain alignment may be implemented, according to some embodiments of the present disclosure. The IC structure 100B is similar to the IC structure 100A in that it may include the substrate 110, the device layer 120, and the metallization stack 140 comprising the metal layers 130, as described above. In addition, as shown in FIG. 1B, the IC structure 100B further includes metal layers 160 on the back side of the substrate 110, the metal layers 160 individually labeled as a metal layer 160-1 through metal layer 160-M, where M is an integer equal to or greater than 1 and may, but does not have to be, equal to N. The metal layers 160 may be referred to as "backside metal layers" or "backside metallization stack" and the descriptions provided with respect to the metal layers 130 on the front side are applicable to the metal layers 160 on the back side and, in the interest of brevity, are not repeated. FIG. 1B illustrates that, in some embodiments, the BPD arrangement 180 may be implemented as part of one or more metal layers 160.

FIG. 1C illustrates a cross-sectional view of an example IC structure 100C in which a BPD arrangement using conductive materials with preferential grain alignment may be implemented, according to some embodiments of the present disclosure. The IC structure 100C is similar to the IC structure 100B except that the IC structure 100C does not include the substrate 110. Instead, the metal layers 160 are provided directly over the back side of the device layer 120. In the IC structure 100C, once all of the layers on the front side have been fabricated and the IC structure 100C has been flipped over to continue with fabrication of the metal layers 160 on the back side, the substrate 110 may be thinned (e.g., polished, etched, or otherwise removed) to the point that terminals of the components of the device layer 120 (e.g., S/D regions of the transistors in the device layer 120) may be contacted from the back side. The metal layers 160 may then be provided directly over the back side of the device layer 120. Thus, as shown in FIG. 1C, the substrate 110 may be substantially removed (but the portions of the substrate 110 in which the frontend devices of the device layer 120 were fabricated remain), and the device layer 120 may be between the metal layers 130 on the front side and the metal layers 160 on the back side. Similar to FIG. 1B, FIG. 1C illustrates that, in some embodiments, the BPD arrangement 180 may be implemented as part of one or more metal layers 160 on the back side of the device layer 120.

FIG. 2A illustrates a cross-sectional side view of an example IC structure 200A that may include a BPD arrangement 180 using conductive materials with preferential grain alignment in accordance with any of the embodiments disclosed herein. The IC structure 200A shown in FIG. 2A is an example of the IC structure 100A of FIG. 1A, as explained below.

The IC structure 200A may be formed on a substrate 210, where the substrate 210 may be any suitable support structure as described herein, e.g., the substrate 110 of FIG. 1A and/or the wafer 2000 of FIG. 6. The substrate 210 may be part of a singulated die (e.g., the dies 2002 of FIG. 6) or a wafer (e.g., the wafer 2000 of FIG. 6).

The IC structure 200A may include one or more device layers 220 disposed on the substrate 210, where, together, the one or more device layers 220 may be an example of the device layer 120 of the IC structure 100A. The device layer 220 may include features of one or more transistors 222 (e.g., metal-oxide-semiconductor field-effect transistors (MOSFETs)) formed on the substrate 210, e.g., channel regions/portions of the transistors 222 may be portions of the uppermost layers of the substrate 210. The device layer 220 may include, for example, source and/or drain (S/D) regions 224, gates 226 to control current flow in the transistors 222 between their S/D regions 224, channel regions 225 between S/D regions 224 in each of the transistors 222, and S/D contacts 228 to route electrical signals to/from the S/D regions 224. The transistors 222 may include additional features not depicted for the sake of clarity, such as device isolation regions, gate contacts, and the like. Details of an individual transistor 222, e.g., a transistor 222 enclosed within a dashed contour in the IC structure 200A are shown in FIG. 2A within a dotted contour shown to the left of the IC structure 200A, where an enlarged version of the transistor 222 is shown. However, the transistors 222 are not limited to the type and configuration depicted in FIG. 2A and may include a wide variety of other types and configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon and nanowire transistors.

As shown in FIG. 2A, a channel region 225 may be a region of a semiconductor material, between the first and second S/D regions 224 of the transistor 222, in which a channel of the transistor 222 forms during operation of the transistor 222. In general, the channel region 225 may be composed of semiconductor material systems including, for example, N-type or P-type materials systems. In some embodiments, the channel region 225 may include a substantially monocrystalline semiconductor, such as silicon (Si) or germanium (Ge). In some embodiments, the channel region 225 may include a compound semiconductor with a first sub-lattice of at least one element from group III of the periodic table (e.g., Al, Ga, In), and a second sub-lattice of at least one element of group V of the periodic table (e.g., P, As, Sb). In some embodiments, the channel region 225 may include a high mobility oxide semiconductor material, such as tin oxide, antimony oxide, indium oxide, indium tin oxide, titanium oxide, zinc oxide, indium zinc oxide, gallium oxide, titanium oxynitride, ruthenium oxide, or tungsten oxide. In some embodiments, the channel region 225 may include a combination of semiconductor materials.

For some example N-type transistor embodiments (i.e., for the embodiments where a transistor 222 is an N-type metal-oxide-semiconductor (NMOS) transistor), the channel region 225 may include a III-V material having a relatively high electron mobility, such as, but not limited to InGaAs, InP, InSb, and InAs. For some such embodiments, the channel region 225 may be a ternary III-V alloy, such as InGaAs, GaAsSb, InAsP, or InPSb. For some InₓGa₁₋ₓAs fin embodiments, In content (x) may be between 0.6 and 0.9, and may advantageously be at least 0.7 (e.g., In_{0.7}Ga_{0.3}As). For some example P-type transistor embodiments (i.e., for the embodiments where a transistor 222 is a P-type metal-oxide-semiconductor (PMOS) transistor), the channel region 225 may advantageously be a group IV material having a high hole mobility, such as, but not limited to Ge or a Ge-rich SiGe alloy. For some example embodiments, the channel region 225 may have a Ge content between 0.6 and 0.9, and advantageously may be at least 0.7.

In some embodiments, the channel region 225 may be a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, the channel region 225 may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, N- or P-type amorphous or polycrystalline silicon, germanium, indium gallium arsenide, silicon germanium, gallium nitride, aluminum gallium nitride, indium phosphite, and black phosphorus, each of which may possibly be doped with one or more of gallium, indium, aluminum, fluorine, boron, phosphorus, arsenic, nitrogen, tantalum, tungsten, and magnesium, etc.

As noted above, the channel region 225 may include IGZO. IGZO-based devices have several desirable electrical and manufacturing properties. IGZO has high electron mobility compared to other semiconductors, e.g., in the range of 20-50 times than amorphous silicon. Furthermore, amorphous IGZO (a-IGZO) transistors are typically characterized by high band gaps, low-temperature process compatibility, and low fabrication cost relative to other semiconductors. IGZO can be deposited as a uniform amorphous phase while retaining higher carrier mobility than oxide semiconductors such as zinc oxide. Different formulations of IGZO include different ratios of indium oxide, gallium oxide, and zinc oxide. One particular form of IGZO has the chemical formula InGaO₃(ZnO)₅. Another example form of IGZO has an indium:gallium:zinc ratio of 1:2:1. In various other examples, IGZO may have a gallium to indium ratio of 1:1, a gallium to indium ratio greater than 1 (e.g., 2:1, 3:1, 4:1, 5:1, 6:1, 7:1, 8:1, 9:1, or 10:1), and/or a gallium to indium ratio less than 1 (e.g., 1:2, 1:3, 1:4, 1:5, 1:6, 1:7, 1:8, 1:9, or 1:10). IGZO can also contain tertiary dopants such as aluminum or nitrogen.

In some embodiments, a transistor 222 may be a thin-film transistor (TFT). A TFT is a special kind of a field-effect transistor (FET) made by depositing a thin film of an active semiconductor material over a support (e.g., a support structure as described above) that may be a non-conducting support. Some such materials may be deposited at relatively low temperatures, which allows depositing them within the thermal budgets to avoid damaging other components such as the logic devices of an IC structure. At least a portion of the active semiconductor material forms a channel of the TFT. In some such embodiments, the channel region 225 may be a semiconductor material deposited at relatively low temperatures and may include any of the oxide semiconductor materials described above.

In other embodiments, instead of having semiconductor materials deposited at relatively low temperatures as described above with reference to the TFTs, the channel region 225 may include one or more semiconductor materials that are epitaxially grown in what typically involves relatively high-temperature processing. In such embodiments, the channel region 225 may include any of the semiconductor materials described above, including oxide semiconductor materials. In some such embodiments, the channel region 225 may be a semiconductor material epitaxially grown directly on a semiconductor layer of the substrate 210, in a process known as "monolithic integration." In other such embodiments, the channel region 225 may be a semiconductor material epitaxially grown on a semiconductor layer of another support structure and then the epitaxially grown layer of the channel region 225 may be transferred, in a process known as a "layer transfer," to the substrate 210, in which case the substrate 210 may but does not have to include a semiconductor layer prior to the layer transfer. Layer transfer advantageously allows forming transistors over support structures or in layers that do not include semiconductor materials (e.g., in the backend of an IC device). Layer transfer also advantageously allows forming transistors of any architecture (e.g., non-planar or planar transistors) without imposing the negative effects of the relatively high-temperature epitaxial growth process on devices that may already be present over a support structure.

The semiconductor material of the channel region 225 that is deposited at relatively low temperatures is typically a polycrystalline, polymorphous, or amorphous semiconductor, or any combination thereof. The semiconductor material of the channel region 225 that is epitaxially grown is typically a highly crystalline (e.g., monocrystalline, or single-crystalline) material. Therefore, whether the semiconductor material of the channel region 225 is deposited at relatively low temperatures or epitaxially grown can be identified by inspecting grain size of the active portions of the channel region 225. An average grain size of the semiconductor material of the channel region 225 being between about 0.5 and 1 millimeters (in which case the material may be polycrystalline) or smaller than about 0.5 millimeter (in which case the material may be polymorphous or amorphous) may be indicative of the semiconductor material of the channel region 225 having been deposited using a low-temperature process. On the other hand, an average grain size of the semiconductor material of the channel region 225 being equal to or greater than about 1 millimeter (in which case the material may be a single-crystal material) may be indicative of the semiconductor material of the channel region 225 having been epitaxially grown and included in the IC structure either by monolithic integration or by layer transfer.

The S/D regions 224, individually labeled within the dotted contour showing an enlarged version of the transistor 222 as a S/D region 224-1 and a S/D region 224-2, may be formed within the substrate 210 adjacent to the gate 226 of each transistor 222, on either side of the channel region 225, using any suitable processes known in the art. For example, the S/D regions 224 may be formed using either an implantation/diffusion process or a deposition process. In the former process, dopants such as boron, aluminum, antimony, phosphorous, or arsenic may be ion-implanted into the substrate 210 to form the S/D regions 224. An annealing process that activates the dopants and causes them to diffuse farther into the substrate 210 may follow the ion implantation process. In the latter process, an epitaxial deposition process may provide material that is used to fabricate the S/D regions 224. In some implementations, the S/D regions 224 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 224 may be formed using one or more alternate semiconductor materials such as germanium or a group III-V material or alloy. In further embodiments, one or more layers of metal and/or metal alloys may be used to form the S/D regions 224. In some embodiments, an etch process may be performed before the epitaxial deposition to create recesses in the substrate 210 in which the material for the S/D regions 224 is deposited.

Each transistor 222 may include a gate 226 that includes a gate electrode material 227 and, in some embodiments, a gate insulator 229.

The gate electrode material 227 may include a P-type workfunction metal or N-type workfunction metal, depending on whether the transistor 222 is to be a PMOS or an NMOS transistor, respectively. In some implementations, the gate electrode material 227 may include a stack of two or more metal layers, where one or more metal layers are workfunction metal layers and at least one metal layer is a fill metal layer. Further metal layers may be included for other purposes, such as a barrier layer or/and an adhesion layer. For a PMOS transistor, metals that may be used for the gate electrode material 227 include, but are not limited to, ruthenium, palladium, platinum, cobalt, nickel, and conductive metal oxides, e.g., ruthenium oxide. A P-type metal layer will enable the formation of a PMOS gate electrode with a workfunction that is between about 4.9 electron Volts (eV) and about 5.2 eV. For an NMOS transistor, metals that may be used for the gate electrode material 227 include, but are not limited to, hafnium, zirconium, titanium, tantalum, aluminum, alloys of these metals, and carbides of these metals such as hafnium carbide, zirconium carbide, titanium carbide, tantalum carbide, aluminum carbide, tungsten, tungsten carbide. An N-type metal layer will enable the formation of an NMOS gate electrode with a workfunction that is between about 3.9 eV and about 4.2 eV.

In some embodiments, when viewed as a cross-section of the transistor 222 along the source-channel-drain direction, the gate electrode material 227 may be formed as a U-shaped structure that includes a bottom portion substantially parallel to the surface of the substrate and two sidewall portions that are substantially perpendicular to the top surface of the substrate. In other embodiments, at least one of the metal layers that form the gate electrode may simply be a planar layer that is substantially parallel to the top surface of the substrate and does not include sidewall portions substantially perpendicular to the top surface of the substrate. In other embodiments, the gate electrode material 227 may be formed as a combination of U-shaped structures and planar, non-U-shaped structures. For example, the gate electrode material 227 may be implemented as one or more U-shaped metal layers formed atop one or more planar, non-U-shaped layers. In some embodiments, the gate electrode material 227 may be a V-shaped structure (e.g., when a fin of a FinFET transistor does not have a "flat" upper surface, but instead has a rounded peak).

In some embodiments, the gate insulator 229 may include one or more high-k dielectrics, e.g., insulator materials including elements such as hafnium, silicon, oxygen, titanium, tantalum, lanthanum, aluminum, zirconium, barium, strontium, yttrium, lead, scandium, niobium, and zinc. Examples of high-k materials that may be used for this purpose may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In some embodiments, an annealing process may be carried out on the gate insulator 229 during fabrication of the IC structures to improve the quality of the gate insulator 229. The gate insulator 229 may have a thickness that may, in some embodiments, be between about 0.5 nanometers and 10 nanometers, including all values and ranges therein (e.g., between about 0.5 and 3 nanometers, between about 1 and 3 nanometers, or between about 1 and 2 nanometers).

In some embodiments, e.g., when the transistor 222 is a storage transistor of a hysteretic memory cell (i.e., a type of memory that functions based on the phenomenon of hysteresis), the gate insulator 229 may be replaced with, or complemented by, a hysteretic material or a hysteretic arrangement, which, together, may be referred to as a "hysteretic element." Transistors in which the gate insulator 229 includes a hysteretic element may be described as "hysteretic transistors" and may be used to implement hysteretic memory. Hysteretic memory refers to a memory technology employing hysteretic materials or arrangements, where a material or an arrangement may be described as hysteretic if it exhibits the dependence of its state on the history of the material (e.g., on a previous state of the material). Ferroelectric (FE) and antiferroelectric (AFE) materials are one example of hysteretic materials. Layers of different materials arranged in a stack to exhibit charge-trapping phenomena is one example of a hysteretic arrangement.

A FE or an AFE material is a material that exhibits, over some range of temperatures, spontaneous electric polarization, i.e., displacement of positive and negative charges from their original position, where the polarization can be reversed or reoriented by application of an electric field. In particular, an AFE material is a material that can assume a state in which electric dipoles from the ions and electrons in the material may form a substantially ordered (e.g., substantially crystalline) array, with adjacent dipoles being oriented in opposite (antiparallel) directions (i.e., the dipoles of each orientation may form interpenetrating sub-lattices, loosely analogous to a checkerboard pattern), while a FE material is a material that can assume a state in which all of the dipoles point in the same direction. Because the displacement of the charges in FE and AFE materials can be maintained for some time even in the absence of an electric field, such materials may be used to implement memory cells. Because the current state of the electric dipoles in FE and AFE materials depends on the previous state, such materials are hysteretic materials. Memory technology where logic states are stored in terms of the orientation of electric dipoles in (i.e., in terms of polarization of) FE or AFE materials is referred to as "FE memory," where the term "ferroelectric" is said to be adopted to convey the similarity of FE memories to ferromagnetic memories, despite the fact that there is typically no iron (Fe) present in FE or AFE materials.

A stack of alternating layers of materials that is configured to exhibit charge-trapping is an example of a hysteretic arrangement. Such a stack may include as little as two layers of materials, one of which is a charge-trapping layer (i.e., a layer of a material configured to trap charges when a volage is applied across the material) and the other one of which is a tunnelling layer (i.e., a layer of a material through which the charge is to be tunneled to the charge-trapping layer). The tunnelling layer may include an insulator material such as a material that includes silicon and oxygen (e.g., silicon oxide), or any other suitable insulator. The charge-trapping layer may include a metal or a semiconductor material that is configured to trap charges. For example, a material that includes silicon and nitrogen (e.g., silicon nitride) may be used in/as a charge-trapping layer. Because the trapped charges may be kept in a charge-trapping arrangement for some time even in the absence of an electric field, such arrangements may be used to implement memory cells. Because the presence and/or the amount of trapped charges in a charge-trapping arrangement depends on the previous state, such arrangements are hysteretic arrangements. Memory technology where logic states are stored in terms of the amount of charge trapped in a hysteretic arrangement may be referred to as "charge-trapping memory."

Hysteretic memories have the potential for adequate non-volatility, short programming time, low power consumption, high endurance, and high speed writing. In addition, hysteretic memories may be manufactured using processes compatible with the standard CMOS technology. Therefore, over the last few years, these types of memories have emerged as promising candidates for many growing applications.

In some embodiments, the hysteretic element of the gate insulator 229 may be provided as a layer of a FE or an AFE material. Such an FE/AFE material may include one or more materials that can exhibit sufficient FE/AFE behavior even at thin dimensions, such as an insulator material at least about 5%, e.g., at least about 7% or about 10%, of which is in an orthorhombic phase and/or a tetragonal phase (e.g., as a material in which at most about 95-90% of the material may be amorphous or in a monoclinic phase). For example, such materials may be based on hafnium and oxygen (e.g., hafnium oxides), with various dopants added to ensure sufficient amount of an orthorhombic phase or a tetragonal phase. Some examples of such materials include materials that include hafnium, oxygen, and zirconium (e.g., hafnium zirconium oxide (HfZrO, also referred to as HZO)), materials that include hafnium, oxygen, and silicon (e.g., silicon-doped (Si-doped) hafnium oxide), materials that include hafnium, oxygen, and germanium (e.g., germanium-doped (Ge-doped) hafnium oxide), materials that include hafnium, oxygen, and aluminum (e.g., aluminum-doped (Al-doped) hafnium oxide), and materials that include hafnium, oxygen, and yttrium (e.g., yttrium-doped (Y-doped) hafnium oxide). However, in other embodiments, any other materials which exhibit FE/AFE behavior at thin dimensions may be used as the hysteretic element and are within the scope of the present disclosure.

In other embodiments, the hysteretic element of the gate insulator 229 may be provided as a stack of alternating layers of materials that can trap charges. In some such embodiments, the stack may be a two-layer stack, where one layer is a charge-trapping layer and the other layer is a tunnelling layer. The tunnelling layer may include an insulator material such as a material that includes silicon and oxygen (e.g., silicon oxide), or any other suitable insulator. The charge-trapping layer may include an electrically conductive material such as a metal, or a semiconductor material, that is a charge-trapping material. In some embodiments, the charge-trapping layer may include a material that includes silicon and nitrogen (e.g., silicon nitride). In general, any material that has defects that can trap charge may be used in/as a charge-trapping material. Such defects are very detrimental to operation of logic devices and, therefore, typically, deliberate steps need to be taken to avoid presence of the defects. However, for memory devices, such defects may be desirable because charge-trapping may be used to represent different memory states of a memory cell. In some embodiments, the tunnelling layer may be omitted, and the hysteretic element of the gate insulator 229 may be provided as a charge-trapping material, e.g., a material that includes silicon and nitrogen (e.g., silicon nitride) or, more generally, any material that has defects that can trap charge.

In some embodiments of the hysteretic element being provided as a stack of alternating layers of materials that can trap charges, the stack may be a three-layer stack where an insulator material is provided on both sides of a charge-trapping layer. In such embodiments, a layer of an insulator material on one side of the charge-trapping layer may be referred to as a "tunnelling layer" while a layer of an insulator material on the other side of the charge-trapping layer may be referred to as a "field layer."

In various embodiments of the hysteretic element being provided as a stack of alternating layers of materials that can trap charges, a thickness of each layer the stack may be between about 0.5 and 10 nanometers, including all values and ranges therein, e.g., between about 0.5 and 5 nanometers. In some embodiment of a three-layer stack, a thickness of each layer of the insulator material may be about 0.5 nanometers, while a thickness of the charge-trapping layer may be between about 1 and 8 nanometers, e.g., between about 2.5 and 7.5 nanometers, e.g., about 5 nanometers. In some embodiments, a total thickness of the hysteretic element provided as a stack of alternating layers of materials that can trap charges (i.e., a hysteretic arrangement) may be between about 1 and 10 nanometers, e.g., between about 2 and 8 nanometers, e.g., about 6 nanometers.

Electrical signals, such as power and/or input/output (I/O) signals, may be routed to and/or from the transistors 222 and other components of the device layer 220 through one or more metal layers 230 disposed on the device layer 220, illustrated in FIG. 2A as metal layers 230-1, 230-2, and 230-3. For example, electrically conductive features of the device layer 220 (e.g., the gate 226 and the S/D contacts 228) may be electrically coupled with the interconnect structures 232 of the metal layers 230. Although a particular number of metal layers 230 is depicted in FIG. 2A, embodiments of the present disclosure include IC devices having more or fewer metal layers than depicted. The one or more metal layers 230 may form a metallization stack 240 of the IC structure 200A. The metal layers 230 are examples of the metal layers 130 of the IC structure 100A, and the metallization stack 240 is an example of the metallization stack 140 of the IC structure 100A.

The interconnect structures 232, which may also be referred to as "backend interconnect structures" because they are in the metal layers 230 which are in the backend of the IC structure 200A, may be arranged within the metal layers 230 to route electrical signals according to a wide variety of designs (in particular, the arrangement is not limited to the particular configuration of interconnect structures 232 depicted in FIG. 2A). In some embodiments, the interconnect structures 232 may include conductive lines 232a and/or conductive vias 232b, formed of an electrically conductive material such as a metal. The conductive lines 232a may be arranged to route electrical signals in a direction of a plane that is substantially parallel with a surface of the substrate 210 upon which the device layer 220 is formed. For example, the conductive lines 232a may route electrical signals in a direction in and out of the page from the perspective of FIG. 2A. The conductive vias 232b may be arranged to route electrical signals in a direction of a plane that is substantially perpendicular to the surface of the substrate 210 upon which the device layer 220 is formed. In some embodiments, the conductive vias 232b may electrically couple conductive lines 232a of different metal layers 230 together.

A first metal layer 230-1 (referred to as Metal 1 or "M1") may be formed directly on the device layer 220. In some embodiments, the first metal layer 230-1 may include conductive lines 232a and/or conductive vias 232b, as shown. The conductive lines 232a of the first metal layer 230-1 may be coupled with contacts (e.g., the S/D contacts 228) of the device layer 220.

A second metal layer 230-2 (referred to as Metal 2 or "M2") may be formed directly on the first metal layer 230-1. In some embodiments, the second metal layer 230-2 may include conductive vias 232b to couple the conductive lines 232a of the second metal layer 230-2 with the conductive lines 232a of the first metal layer 230-1. Although the conductive lines 232a and the conductive vias 232b are structurally delineated with a line within each metal layer (e.g., within the second metal layer 230-2) for the sake of clarity, the conductive lines 232a and the conductive vias 232b may be structurally and/or materially contiguous (e.g., simultaneously filled during a dual-damascene process) in some embodiments.

A third metal layer 230-3 (referred to as Metal 3 or "M3") (and additional metal layers, as desired) may be formed in succession on the second metal layer 230-2 according to similar techniques and configurations described in connection with the second metal layer 230-2 or the first metal layer 230-1.

The metal layers 230 may include an insulator material 234 disposed between the interconnect structures 232, as shown in FIG. 2A. The insulator material 234 may take the form of any of the embodiments of the insulator materials provided between the interconnects of IC structures, for example any of the embodiments discussed herein with reference to the insulating medium of the metallization stack 140. In some embodiments, the insulator material 234 disposed between the interconnect structures 232 in different ones of the metal layers 230 may have different compositions. In other embodiments, the composition of the insulator material 234 in different metal layers 230 may be the same.

The IC structure 200A may include a solder resist material 236 (e.g., polyimide or similar material) and one or more conductive contacts 238 (e.g., bond pads) formed on the metal layers 230. The conductive contacts 238 may be electrically coupled with the interconnect structures 232 and configured to route the electrical signals of the transistor(s) 222 to other external devices. For example, solder bonds may be formed on the one or more conductive contacts 238 to mechanically and/or electrically couple a chip including the IC structure 200A with another component (e.g., a circuit board). The IC structure 200A may have other alternative configurations to route the electrical signals from the metal layers 230 than depicted in other embodiments. For example, the conductive contacts 238 illustrated in FIG. 2A as bond pads may be replaced by or may further include other analogous features (e.g., posts) that route the electrical signals to external components.

As shown in FIG. 2A, a BPD arrangement 280 using conductive materials with preferential grain alignment may be provided on the back side of the substrate 210. The BPD arrangement 280 shown in FIG. 2A is an example of the BPD arrangement 180 of FIG. 1A. To that end, front-to-back interconnect structures 282 may provided in the IC structure 200A, extending between the front side and the back side of the substrate 210. An backside layer 284 may be provided on the back side of the substrate 210 and the BPD arrangement 280 may include one or more BPD interconnect structures 290 that use one or more conductive materials with preferential grain alignment, where the BPD interconnect structures 290 may be surrounded on the sides by the material of the backside layer 284. In some embodiments, the backside layer 284 may include an insulator material, e.g., any of the ILD materials described above. Although a particular number of BPD interconnect structures 290 is depicted in FIG. 2A, embodiments of the present disclosure include IC devices having more or fewer BPD interconnect structures 290 than depicted. The BPD interconnect structures 290 may be arranged on the back side of the substrate 210 to support power delivery from the back side of the substrate 210 according to a wide variety of designs (in particular, the arrangement is not limited to the particular configuration of the BPD interconnect structures 290 depicted in FIG. 2A). Individual ones of the BPD interconnect structures 290 may be implemented according to any architecture. For example, in some embodiments, one or more of the BPD interconnect structures 290 may be implemented as conductive lines (e.g., similar to the conductive lines 232a). In some embodiments, one or more of the BPD interconnect structures 290 may be implemented as conductive vias (e.g., similar to the conductive vias 232b). In some embodiments, within a single IC structure 200A, some of the BPD interconnect structures 290 may be implemented as conductive lines while other ones may be implemented as conductive vias.

An individual BPD interconnect structure 290 may include a liner of a barrier material 292 and a conductive material 294. The barrier material 292 may include any suitable material, or a combination of materials, that can reduce or eliminate electromigration of the conductive material 294. For example, the barrier material 292 may include one or more of tungsten, titanium, titanium and nitrogen (e.g., titanium nitride), tantalum, tantalum and nitrogen (e.g., tantalum nitride), nickel, nickel and silicon (e.g., nickel silicide), cobalt, or cobalt and silicon (e.g., cobalt silicide).

The conductive material 294 in at least some of the BPD interconnect structures 290 may include any suitable conductive metals, e.g., copper, aluminum, tungsten, or cobalt, or metal alloys, or more generally, any suitable electrically conductive material(s) that may be provided so that they have a preferential grain alignment. As used herein, the conductive material 294 having a "preferential grain alignment" refers to the conductive material 294 exhibiting a non-random orientation of crystal grains within the conductive material 294. In some embodiments, the conductive material 294 having a "preferential grain alignment" may include any suitable conductive material in which a majority of grains are oriented substantially along a single general direction, possibly within a maximum deviation from that direction of, e.g., 15 degrees or 10 degrees. The conductive material 294 with preferential grain alignment may be referred to as textured or anisotropic conductive material. As described above, embodiments of the present disclosure are based on recognition that conductive materials that have preferential grain alignment have a reduced affinity to electromigration, compared to polycrystalline conductive materials. Because of the reduced affinity to electromigration, using the conductive material 294 within the openings for the BPD interconnect structures 290 lined with the barrier material 292 may allow reducing the thickness of the barrier material 292 and, hence, reduce the overall resistance of the BPD arrangement 280 while preserving adequate performance (e.g., in terms of electromigration). In some embodiments, a thickness of the barrier material 292 may, advantageously, be below about 50 nanometers, e.g., below about 30 nanometers, or below about 20 or 15 nanometers. For example, for <111> grain orientations with at least 80% of the grains having preferential gain orientation, the thickness of the barrier material 292 may be reduced to below about 20 nanometers. Thus, increasing the preferential grain orientation within the conductive material 294 can mitigate scaling challenges while ensuring the performance and reliability of ever-shrinking interconnects.

The slanted lines in the pattern used in FIG. 2A to illustrate the conductive material 294 are intended to illustrate one example of preferential grain alignment where grains of the conductive material 294 are arranged at an angle to the substrate 210. FIGS. 3A-3C illustrate example cross-sectional side views of conductive materials 294 with preferential grain alignment that may be used in a BPD arrangement, e.g., in the BPD arrangement 280, according to some embodiments of the present disclosure. FIG. 3A illustrates an embodiment where majority of grains 295 of the conductive material 294 extend in horizontal planes (e.g., horizontal with respect to the device layer 220 or to the substrate 210). FIG. 3B illustrates an embodiment where majority of the grains 295 extend in vertical planes (e.g., vertical with respect to the device layer 220 or to the substrate 210). In some embodiments, the conductive material 294 with the majority of grains 295 implemented as shown in FIGS. 3A or 3B could be a nanotwinned conductive material, e.g., nanotwinned copper (NTC). A nanotwinned conductive material may include a specific type of conductive material (e.g., a specific type of copper) that possesses a unique microstructure characterized by a high density of nanoscale twin boundaries. Twin boundaries may interface within a crystal lattice where the crystal structure abruptly changes direction, resulting in twin planes. In NTC, for example, these twin boundaries may be densely packed at the nanometer scale, with spacing typically ranging from a few to tens of nanometers. FIG. 3C illustrates an embodiment where majority of the grains 295 extend along a direction that is between horizontal and vertical as shown in FIGS. 3A and 3B. For example, in some embodiments, majority of the grains 295 may extend along a direction that is at an angle between about 5 degrees and about 85 degrees with respect to the device layer 220, e.g., along a direction that is at an angle between about 35 degrees and about 55 degrees with respect to the device layer 220.

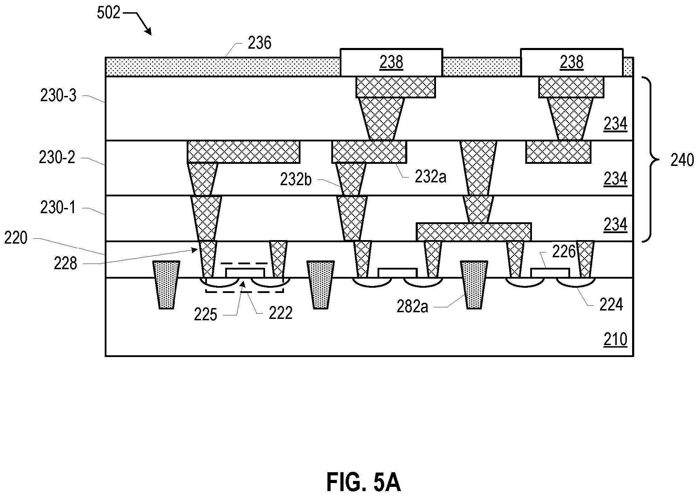

The front-to-back interconnect structures 282 may include any suitable arrangement of interconnect structures (e.g., any suitable combination of conductive lines and/or conductive vias) that may electrically connect individual ones of the BPD interconnect structures 290 to various terminals of devices of the device layer 220 and/or to various interconnect structures 232 at the front side of the device layer 220. In some embodiments, an individual front-to-back interconnect structure 282 may include a first interconnect structure 282a and a second interconnect structure 282b, in conductive contact (e.g., electrically continuous) with one another. In some embodiments, cross-sectional shapes of the first interconnect structures 282a and the second interconnect structures 282b may be substantially trapezoidal, as shown in FIG. 2A, but with the trapezoids having their short sides facing different directions (e.g., with the trapezoids having their short sides facing one another, as is shown in FIG. 2A). Such trapezoidal shapes may be indicative of the manufacturing processes used to fabricate the first interconnect structures 282a and the second interconnect structures 282b, as well as the side from which the processing is performed to fabricate them, as will be discussed in more detail with reference to FIGS. 5A-5F. In some embodiments, conductive materials of the front-to-back interconnect structures 282 may be different from the conductive material 294 (e.g., may have a different material composition). For example, the conductive material 294 may include copper with preferential grain orientation, while the front-to-back interconnect structures 282 may include metals other than copper. In some embodiments, the front-to-back interconnect structures 282 may include metals that are less likely to electromigrate/diffuse than copper. In such embodiments, the 282 may not include a barrier liner such as the barrier material 292 because it is not needed.

As shown in FIG. 2B, a BPD arrangement 280 using conductive materials with preferential grain alignment may include a plurality of BPD interconnect structures 290 distributed through one or more metal layers 260 provided on the back side of the substrate 210 or the device layer 220. The BPD arrangement 280 shown in FIG. 2B is an example of the BPD arrangement 180 of FIG. 1B.

As shown in FIG. 2B, the IC structure 200B is similar to the IC structure 200A in that it may include the substrate 210, and, at the front side of the IC structure 200B, further include the device layer 220, and the metallization stack 240 comprising the metal layers 230 with the interconnect structures 232, as described above. In addition, as shown in FIG. 2B, the IC structure 200B may further include one or more metal layers 260, illustrated in FIG. 2B as metal layers 260-1, 260-2, and 260-3, disposed on the back side of the IC structure 200B, e.g., on the back side of the substrate 210, where the metal layers 260 may be an example of the metal layers 160 of the IC structure 100B.

Electrical signals, such as power and/or input/output (I/O) signals, may be routed to and/or from the transistors 222 and other components of the device layer 220 and/or of the device layer 250 through one or more metal layers 260 disposed at the back side of the substrate 210, e.g., over the device layer 250, illustrated in FIG. 2B as metal layers 260-1, 260-2, and 260-3. For example, electrically conductive features of the device layer 220 (e.g., the gate 226 and the S/D contacts 228) and/or of the device layer 250 may be electrically coupled with the interconnect structures 262 of the metal layers 260. Although a particular number of metal layers 260 is depicted in FIG. 2B, embodiments of the present disclosure include IC devices having more or fewer metal layers than depicted.

The interconnect structures 262, which may also be referred to as "backside interconnect structures" because they are in the metal layers 260 which are at the back side of the IC structure 200B, may be arranged within the metal layers 260 to route electrical signals according to a wide variety of designs (in particular, the arrangement is not limited to the particular configuration of interconnect structures 262 depicted in FIG. 2B). In some embodiments, the interconnect structures 262 may include conductive lines 262a and/or conductive vias 262b, formed of an electrically conductive material such as a metal. Descriptions provided with respect to the metal layers 230, the interconnect structures 232, the conductive lines 232a, and the conductive vias 232b at the front side of the IC structure 200B are applicable to, respectively, the metal layers 260, the interconnect structures 262, the conductive lines 262a, and the conductive vias 262b at the back side of the IC structure 200B and, in the interest of brevity, are not repeated.

The metal layers 260 at the back side of the IC structure 200B may include an insulator material 264 disposed between the interconnect structures 262, as shown in FIG. 2B. The IC structure 200B may include a solder resist material 266 (e.g., polyimide or similar material) and one or more conductive contacts 268 (e.g., bond pads) formed on the metal layers 260. Descriptions provided with respect to the insulator material 234, the solder resist material 236, and the conductive contacts 238 at the front side of the IC structure 200B are applicable to, respectively, the insulator material 264, the solder resist material 266, and the conductive contacts 268 at the back side of the IC structure 200B and, in the interest of brevity, are not repeated.

In some embodiments, a series of the interconnect structures 262 between a given one of the front-to-back interconnect structures 282 and one of the conductive contacts 268 may be implemented as BPD interconnect structures 290. For example, a series of the interconnect structures 262 enclosed within a dashed contour in the IC structure 200B may be implemented as shown in FIG. 2B within a dotted contour shown to the left of the IC structure 200B, where the interconnect structures 262 are implemented as the BPD interconnect structures 290.

FIG. 4 is a flow diagram of a fabrication method 400 for providing an IC structures with a BPD arrangement using conductive materials with preferential grain alignment, in accordance with some embodiments. Although the operations of the method 400 are illustrated once each and in a particular order, the operations may be performed in any suitable order and repeated as desired. For example, one or more operations may be performed in parallel to fabricate multiple TGVs with double liners substantially simultaneously. In another example, one or more operations may be performed in parallel to fabricate multiple BPD arrangements that employ conductive materials with preferential grain alignment substantially simultaneously. In addition, the example fabricating method 400 may include other operations not specifically shown in FIG. 4, such as various cleaning or planarization operations as known in the art. For example, in some embodiments, an IC structure at any stage of fabrication, e.g., a substrate 210 and/or layers of various other materials subsequently deposited thereon, may be cleaned prior to, after, or during any of the processes of the method 400, e.g., to remove oxides, surface-bound organic and metallic contaminants, as well as subsurface contamination. In some embodiments, cleaning may be carried out using e.g., a chemical solutions (such as peroxide), and/or with ultraviolet (UV) radiation combined with ozone, and/or oxidizing the surface (e.g., using thermal oxidation) then removing the oxide (e.g., using hydrofluoric acid (HF)). FIGS. 5A-5F provide cross-sectional side views at various stages in the fabrication of an example IC structure according to the method 400 of FIG. 4, in accordance with some embodiments.

Turning to the details of the fabrication method shown in FIG. 4, the method 400 may begin with a process 402 that includes performing frontside processing and forming frontside interconnect structures for BPD. FIG. 5A illustrates an IC structure 502 that may be an example result of the process 402, showing the substrate 210 with the first interconnect structures 282a therein, the device layer 220, the metal layers 230, and the solder resist material 236 with the conductive contacts 238, as described above.

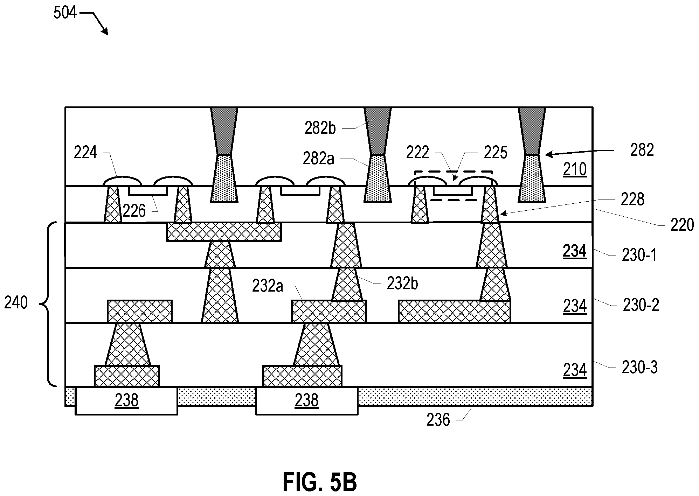

The method 400 may then proceed with a process 404 that includes performing backside processing and forming backside interconnect structures for BPD. FIG. 5B illustrates an IC structure 504 that may be an example result of the process 404, where the IC structure 504 is the same as the IC structure 502 except that it is turned upside down so that further processing can be performed from the back side, and further includes the second interconnect structures 282b formed from the back side and contacting respective first interconnect structures 282a.

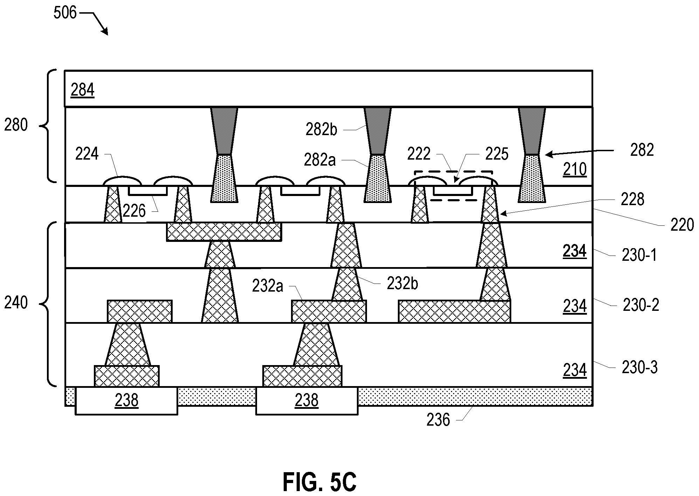

The method 400 may further include a process 406 in which a layer of insulator material is provided at the back side of the IC structure 504. FIG. 5C illustrates an IC structure 506 that may be an example result of the process 406, where the IC structure 506 is the same as the IC structure 504 except that it further includes a backside layer 284 as described herein. Any suitable process may be used to deposit the backside layer 284, such as spin-coating, atomic layer deposition (ALD), chemical vapor deposition (CVD), etc.

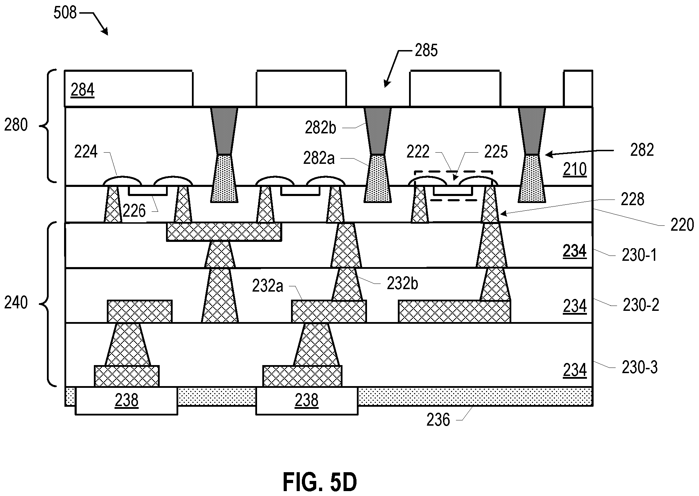

Next, the method 400 may proceed with a process 408 in which openings are formed in the insulator material, the opening being for future BPD interconnect structures at the back side. FIG. 5D illustrates an IC structure 508 that may be an example result of the process 408, where the IC structure 508 is the same as the IC structure 506 except that it further includes openings 285 for future BPD interconnect structures. In various embodiments, the openings 285 may be formed in the backside layer 284 using any suitable subtractive technique such as any suitable etching technique, possibly in combination with any suitable patterning technique such as photolithographic or electron-beam (e-beam) patterning.

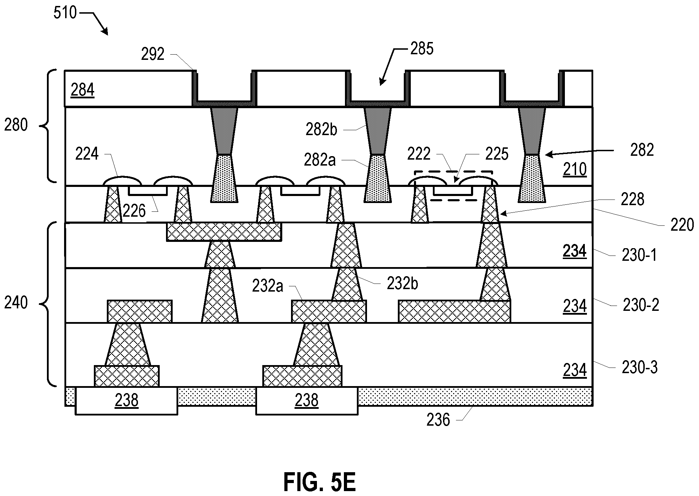

The method 400 may then proceed with a process 410 that includes lining the openings for BPD interconnect structures with a barrier material. FIG. 5E illustrates an IC structure 510 that may be an example result of the process 410, where the IC structure 510 is the same as the IC structure 508 except that it further includes a layer of the barrier material 292 lining sidewalls and bottoms of the openings 285. In various embodiments, the openings 285 may be lined with the barrier material 292 using a conformal deposition technique such as ALD or CVD, so that the barrier material 292 is deposited as a conformal layer, i.e., it may be conformal to the shapes of the underlying surfaces over which the barrier material 292 is deposited.

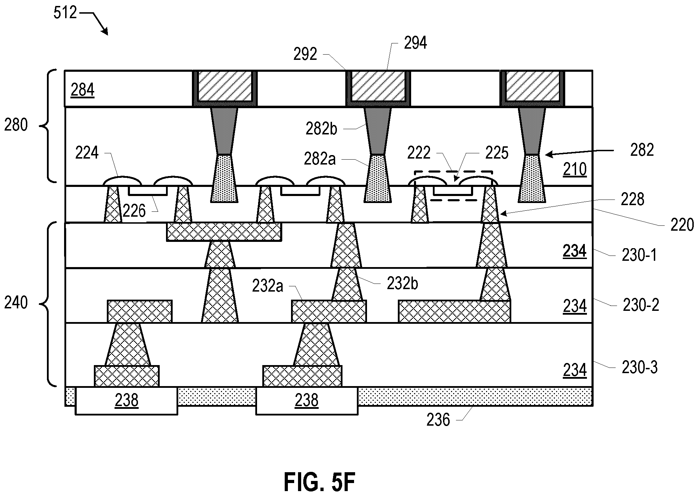

The method 400 further include a process 412 in which the openings 285 for BPD interconnect structures are filled with a conductive material with preferential grain orientation. FIG. 5F illustrates an IC structure 512 that may be an example result of the process 412, where the IC structure 512 is the same as the IC structure 510 except that it further includes the conductive material 294 within the openings 285 lined with the barrier material 292. For example, in some embodiments, the conductive material 294 may have the majority of grains 295 arranged with a preferential orientation as described with reference to FIGS. 3A-3C. In various embodiments, such alignment may be ensured by carefully controlling factors such as processing conditions, external fields during manufacturing, or mechanical deformation during and/or after the process 412. In various embodiments, such alignment may be ensured by carefully controlling factors such as processing conditions, external fields during manufacturing, or mechanical deformation. Although not specifically shown in the drawings, processes 406, 408, 410, and 412 may then be repeated until a desired number of metal layers with BPD interconnect structures 290 are fabricated, e.g., to achieve multiple connected BPD interconnect structures 290, e.g., as shown within the dotted contour on the left side of FIG 2B.

The IC structures with BPD arrangements using conductive materials with preferential grain alignment disclosed herein (e.g., any of the IC structures described with reference to FIGS. 1-5, and/or any of the BPD arrangements 180 or 280, described herein) may be included in any suitable electronic device. FIGS. 6-8 illustrate various examples of apparatuses that may include one or more IC structures with BPD arrangements using conductive materials with preferential grain alignment disclosed herein.

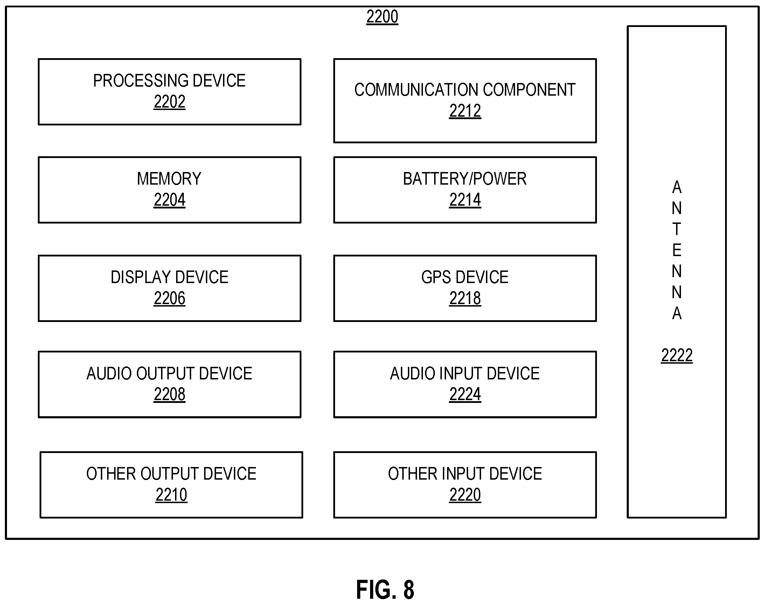

FIG. 6 illustrates top views of a wafer and dies that include one or more IC structures with BPD arrangements using conductive materials with preferential grain alignment in accordance with any of the embodiments disclosed herein. The wafer 2000 may be composed of semiconductor material and may include one or more dies 2002 having IC structures formed on a surface of the wafer 2000. Each of the dies 2002 may be a repeating unit of a semiconductor product that includes any suitable IC structure (e.g., any of the IC structures described with reference to FIGS. 1-5). After the fabrication of the semiconductor product is complete (e.g., after manufacture of one or more IC structures with any of the BPD arrangements using conductive materials with preferential grain alignment as described herein), the wafer 2000 may undergo a singulation process in which each of the dies 2002 is separated from one another to provide discrete "chips" of the semiconductor product. In particular, devices that include one or more IC structures with any of the BPD arrangements using conductive materials with preferential grain alignment as disclosed herein may take the form of the wafer 2000 (e.g., not singulated) or the form of the die 2002 (e.g., singulated). The die 2002 may include one or more transistors (e.g., one or more of the transistors 222 of FIG. 2) and/or supporting circuitry to route electrical signals to the transistors, as well as any other IC components (e.g., any of the BPD arrangements using conductive materials with preferential grain alignment as discussed herein). In some embodiments, the wafer 2000 or the die 2002 may include a memory device (e.g., a static random-access memory (SRAM) device), a logic device (e.g., an AND, OR, NAND, or NOR gate), or any other suitable circuit element. Multiple ones of these devices may be combined on a single die 2002. For example, a memory array formed by multiple memory devices may be formed on a same die 2002 as a processing device (e.g., the processing device 2202 of FIG. 8) or other logic that is configured to store information in the memory devices or execute instructions stored in the memory array.

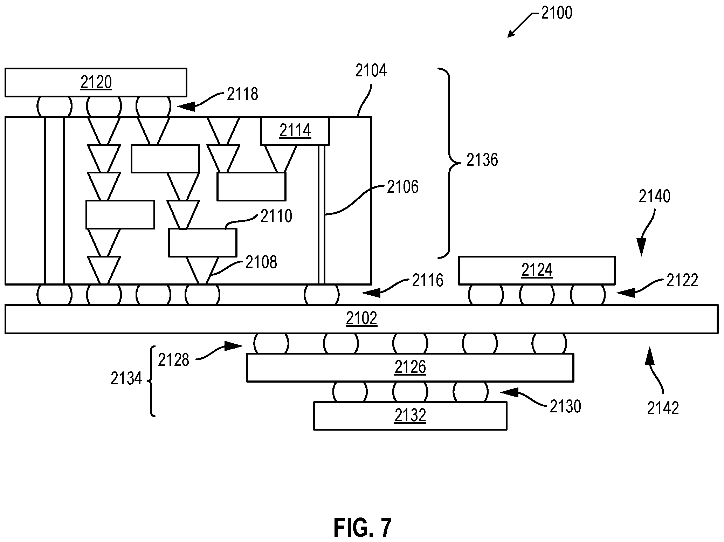

FIG. 7 illustrates a cross-sectional side view of an IC device assembly 2100 that may include components having or being associated with (e.g. being electrically connected by means of) one or more IC structures with one or more BPD arrangements using conductive materials with preferential grain alignment in accordance with any of the embodiments disclosed herein. The IC device assembly 2100 includes a number of components disposed on a circuit board 2102 (which may be, e.g., a motherboard). The IC device assembly 2100 includes components disposed on a first face 2140 of the circuit board 2102 and an opposing second face 2142 of the circuit board 2102; generally, components may be disposed on one or both faces 2140 and 2142. In particular, any suitable ones of the components of the IC device assembly 2100 may include any of the 3D interlocked corrugated capacitor structures, disclosed herein.

In some embodiments, the circuit board 2102 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 2102. In other embodiments, the circuit board 2102 may be a non-PCB substrate.

The IC device assembly 2100 illustrated in FIG. 7 includes a package-on-interposer structure 2136 coupled to the first face 2140 of the circuit board 2102 by coupling components 2116. The coupling components 2116 may electrically and mechanically couple the package-on-interposer structure 2136 to the circuit board 2102, and may include solder balls (as shown in FIG. 7), male and female portions of a socket, an adhesive, an underfill material, and/or any other suitable electrical and/or mechanical coupling structure.

The package-on-interposer structure 2136 may include an IC package 2120 coupled to an interposer 2104 by coupling components 2118. The coupling components 2118 may take any suitable form for the application, such as the forms discussed above with reference to the coupling components 2116. Although a single IC package 2120 is shown in FIG. 7, multiple IC packages may be coupled to the interposer 2104; indeed, additional interposers may be coupled to the interposer 2104. The interposer 2104 may provide an intervening substrate used to bridge the circuit board 2102 and the IC package 2120. The IC package 2120 may be or include, for example, a die (the die 2002 of FIG. 6), an IC device (e.g., any of the IC structures 200 of FIGS. 2A-2B), or any other suitable component. In some embodiments, the IC package 2120 may include one or more IC structures with any of the BPD arrangements using conductive materials with preferential grain alignment, as described herein. Generally, the interposer 2104 may spread a connection to a wider pitch or reroute a connection to a different connection. For example, the interposer 2104 may couple the IC package 2120 (e.g., a die) to a ball grid array (BGA) of the coupling components 2116 for coupling to the circuit board 2102. In the embodiment illustrated in FIG. 7, the IC package 2120 and the circuit board 2102 are attached to opposing sides of the interposer 2104; in other embodiments, the IC package 2120 and the circuit board 2102 may be attached to a same side of the interposer 2104. In some embodiments, three or more components may be interconnected by way of the interposer 2104.

The interposer 2104 may be formed of an epoxy resin, a fiberglass-reinforced epoxy resin, a ceramic material, or a polymer material such as polyimide. In some implementations, the interposer 2104 may be formed of alternate rigid or flexible materials that may include the same materials described above for use in a semiconductor substrate, such as silicon, germanium, and other group III-V and group IV materials. The interposer 2104 may include metal interconnects 2108 and vias 2110, including but not limited to TSVs 2106. The interposer 2104 may further include embedded devices 2114, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency (RF) devices, power amplifiers, power management devices, antennas, arrays, sensors, and microelectromechanical systems (MEMS) devices may also be formed on the interposer 2104. The interposer 2104 may further include one or more 3D interlocked corrugated capacitor structures as described herein. The package-on-interposer structure 2136 may take the form of any of the package-on-interposer structures known in the art.

The IC device assembly 2100 may include an IC package 2124 coupled to the first face 2140 of the circuit board 2102 by coupling components 2122. The coupling components 2122 may take the form of any of the embodiments discussed above with reference to the coupling components 2116, and the IC package 2124 may take the form of any of the embodiments discussed above with reference to the IC package 2120.

The IC device assembly 2100 illustrated in FIG. 7 includes a package-on-package structure 2134 coupled to the second face 2142 of the circuit board 2102 by coupling components 2128. The package-on-package structure 2134 may include an IC package 2126 and an IC package 2132 coupled together by coupling components 2130 such that the IC package 2126 is disposed between the circuit board 2102 and the IC package 2132. The coupling components 2128 and 2130 may take the form of any of the embodiments of the coupling components 2116 discussed above, and the IC packages 2126 and 2132 may take the form of any of the embodiments of the IC package 2120 discussed above. The package-on-package structure 2134 may be configured in accordance with any of the package-on-package structures known in the art.

FIG. 8 illustrates a block diagram of an example computing device 2200 that may include one or more components including one or more IC structures with one or more BPD arrangements using conductive materials with preferential grain alignment in accordance with any of the embodiments disclosed herein. For example, any suitable ones of the components of the computing device 2200 may include a die (e.g., the die 2002 of FIG. 6) having one or more BPD arrangements using conductive materials with preferential grain alignment as described herein. Any one or more of the components of the computing device 2200 may include, or be included in, an IC structure with one or more BPD arrangements using conductive materials with preferential grain alignment as described herein, e.g., any of the IC structures 200 of FIGS. 2A-2B. Any one or more of the components of the computing device 2200 may include, or be included in, an IC device assembly 2100 of FIG. 7.

A number of components are illustrated in FIG. 8 as included in the computing device 2200, but any one or more of these components may be omitted or duplicated, as suitable for the application. In some embodiments, some or all of the components included in the computing device 2200 may be attached to one or more motherboards. In some embodiments, some or all of these components are fabricated onto a single system-on-a-chip (SoC) die.

Additionally, in various embodiments, the computing device 2200 may not include one or more of the components illustrated in FIG. 8, but the computing device 2200 may include interface circuitry for coupling to the one or more components. For example, the computing device 2200 may not include a display device 2206, but may include display device interface circuitry (e.g., a connector and driver circuitry) to which a display device 2206 may be coupled. In another set of examples, the computing device 2200 may not include an audio input device 2224 or an audio output device 2208, but may include audio input or output device interface circuitry (e.g., connectors and supporting circuitry) to which an audio input device 2224 or audio output device 2208 may be coupled.

The computing device 2200 may include a processing device 2202 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 2202 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices. The computing device 2200 may include a memory 2204, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, the memory 2204 may include memory that shares a die with the processing device 2202. This memory may be used as cache memory and may include embedded dynamic random-access memory (eDRAM) or spin transfer torque magnetic random-access memory (STT-MRAM).

In some embodiments, the computing device 2200 may include a communication chip 2212 (e.g., one or more communication chips). For example, the communication chip 2212 may be configured for managing wireless communications for the transfer of data to and from the computing device 2200. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 2212 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 2212 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 2212 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 2212 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 20G, 21G, and beyond. The communication chip 2212 may operate in accordance with other wireless protocols in other embodiments. The computing device 2200 may include an antenna 2222 to facilitate wireless communications and/or to receive other wireless communications (such as AM or FM radio transmissions).

In some embodiments, the communication chip 2212 may manage wired communications, such as electrical, optical, or any other suitable communication protocols (e.g., the Ethernet). As noted above, the communication chip 2212 may include multiple communication chips. For instance, a first communication chip 2212 may be dedicated to shorter-range wireless communications such as Wi-Fi or Bluetooth, and a second communication chip 2212 may be dedicated to longer-range wireless communications such as global positioning system (GPS), EDGE, GPRS, CDMA, WiMAX, LTE, EV-DO, or others. In some embodiments, a first communication chip 2212 may be dedicated to wireless communications, and a second communication chip 2212 may be dedicated to wired communications.

The computing device 2200 may include battery/power circuitry 2214. The battery/power circuitry 2214 may include one or more energy storage devices (e.g., batteries or capacitors) and/or circuitry for coupling components of the computing device 2200 to an energy source separate from the computing device 2200 (e.g., AC line power).

The computing device 2200 may include a display device 2206 (or corresponding interface circuitry, as discussed above). The display device 2206 may include any visual indicators, such as a heads-up display, a computer monitor, a projector, a touchscreen display, a liquid crystal display (LCD), a light-emitting diode display, or a flat panel display, for example.

The computing device 2200 may include an audio output device 2208 (or corresponding interface circuitry, as discussed above). The audio output device 2208 may include any device that generates an audible indicator, such as speakers, headsets, or earbuds, for example.

The computing device 2200 may include an audio input device 2224 (or corresponding interface circuitry, as discussed above). The audio input device 2224 may include any device that generates a signal representative of a sound, such as microphones, microphone arrays, or digital instruments (e.g., instruments having a musical instrument digital interface (MIDI) output).

The computing device 2200 may include a GPS device 2218 (or corresponding interface circuitry, as discussed above). The GPS device 2218 may be in communication with a satellite-based system and may receive a location of the computing device 2200, as known in the art.

The computing device 2200 may include an other output device 2210 (or corresponding interface circuitry, as discussed above). Examples of the other output device 2210 may include an audio codec, a video codec, a printer, a wired or wireless transmitter for providing information to other devices, or an additional storage device.

The computing device 2200 may include an other input device 2220 (or corresponding interface circuitry, as discussed above). Examples of the other input device 2220 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 2200 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 2200 may be any other electronic device that processes data.

The following paragraphs provide various examples of the embodiments disclosed herein.

Example 1 provides an IC structure that includes a device layer including a plurality of transistors, the device layer having a first side and a second side opposite the first side; one or more backend layers at the first side of the device layer, the one or more backend layers including backend interconnects coupled to one or more of the plurality of transistors; and one or more backside layers at the second side of the device layer, the one or more backside layers including an insulator material, an opening in the insulator material, the opening lined with a liner material (e.g., a barrier material), and a conductive material within the opening lined with the liner material, where the conductive material has a preferential grain alignment.

Example 2 provides the IC structure according to example 1, where the opening with the liner material and the conductive material is a backside power delivery (BPD) interconnect structure.

Example 3 provides the IC structure according to example 2, where the BPD interconnect structure is a conductive line.

Example 4 provides the IC structure according to example 2, where the BPD interconnect structure is a conductive via.

Example 5 provides the IC structure according to any one of examples 2-4, where the BPD interconnect structure is electrically coupled to one or more of the plurality of transistors or to one or more of the backend interconnects.

Example 6 provides the IC structure according to any one of examples 1-5, where the conductive material has the preferential grain alignment by having a majority of grains of the conductive material oriented either horizontally or vertically with respect to the device layer.

Example 7 provides the IC structure according to example 6, where the conductive material is a nanotwinned conductive material.

Example 8 provides the IC structure according to example 6, where the conductive material is nanotwinned copper.

Example 9 provides the IC structure according to any one of examples 1-5, where the conductive material has the preferential grain alignment by having a majority of grains of the conductive material oriented along a direction that is at an angle between about 5 degrees and about 85 degrees with respect to the device layer.

Example 10 provides the IC structure according to any one of examples 1-5, where the conductive material has the preferential grain alignment by having a majority of grains of the conductive material oriented along a direction that is at an angle between about 35 degrees and about 55 degrees with respect to the device layer.

Example 11 provides the IC structure according to any one of examples 1-10, where a thickness of the liner material within the opening is below about 50 nanometers.

Example 12 provides an integrated circuit (IC) structure, including an insulator material; and an interconnect structure within the insulator material, where the interconnect structure includes a conductive material and a liner material on sidewalls of the interconnect structure, where at least about 50% of grains of the conductive material are oriented substantially along a direction.

Example 13 provides the IC structure according to example 12, where the interconnect structure is a conductive line.

Example 14 provides the IC structure according to example 12, where the interconnect structure is a conductive via.

Example 15 provides the IC structure according to any one of examples 12-14, where the liner material is further on a top or a bottom of the interconnect structure.

Example 16 provides the IC structure according to any one of examples 12-15, where the liner material is between the insulator material and the conductive material.

Example 17 provides the IC structure according to any one of examples 12-16, where the conductive material includes nanotwinned copper and the liner material includes one or more of tungsten, titanium, tantalum, nickel, or cobalt.

Example 18 provides the IC structure according to example 17, where the liner material further includes nitrogen or silicon.

Example 19 provides an integrated circuit (IC) package, including an IC die; and a further component, coupled to the IC die, where the IC die includes an interconnect structure including a conductive material and a liner material around at least portions of the conductive material, where more than about 50% of grains of the conductive material are aligned along a direction.

Example 20 provides the IC package according to example 19, where the further component is one of a package substrate, an interposer, or a further IC die.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit, IC, structure, comprising:
a device layer comprising a plurality of transistors, the device layer having a first side and a second side opposite the first side;
one or more backend layers at the first side of the device layer, the one or more backend layers comprising backend interconnects coupled to one or more of the plurality of transistors; and
one or more backside layers at the second side of the device layer, the one or more backside layers comprising:
an insulator material,
an opening in the insulator material, the opening lined with a liner material, and
a conductive material within the opening lined with the liner material, wherein the conductive material has a preferential grain alignment.

2. The IC structure according to claim 1, wherein the opening with the liner material and the conductive material is a backside power delivery, BPD, interconnect structure.

3. The IC structure according to claim 2, wherein the BPD interconnect structure is a conductive line or a conductive via.

4. The IC structure according to claims 2 or 3, wherein the BPD interconnect structure is coupled to one or more of the plurality of transistors or to one or more of the backend interconnects.

5. The IC structure according to any one of claims 1-4, wherein the conductive material has the preferential grain alignment by having a majority of grains of the conductive material oriented either horizontally or vertically with respect to the device layer.

6. The IC structure according to claim 5, wherein the conductive material is a nanotwinned conductive material.

7. The IC structure according to any one of claims 1-4, wherein the conductive material has the preferential grain alignment by having a majority of grains of the conductive material oriented along a direction that is at an angle between about 5 degrees and about 85 degrees with respect to the device layer.

8. An integrated circuit, IC, structure, comprising:
an insulator material; and
an interconnect structure within the insulator material, wherein the interconnect structure includes a conductive material and a liner material on sidewalls of the interconnect structure, wherein at least about 50% of grains of the conductive material are oriented substantially along a direction.

9. The IC structure according to claim 8, wherein the interconnect structure is a conductive line or a conductive via.

10. The IC structure according to claims 8 or 9, wherein the liner material is further on a top or a bottom of the interconnect structure.

11. The IC structure according to any one of claims 8-10, wherein the liner material is between the insulator material and the conductive material.

12. The IC structure according to any one of claims 8-11, wherein the conductive material includes nanotwinned copper and the liner material includes one or more of tungsten, titanium, tantalum, nickel, or cobalt.

13. The IC structure according to claim 12, wherein the liner material further includes nitrogen or silicon.

14. An integrated circuit, IC, package, comprising:
an IC die; and
a further component, coupled to the IC die,
wherein the IC die includes an interconnect structure comprising a conductive material and a liner material around at least portions of the conductive material, wherein more than about 50% of grains of the conductive material are aligned along a direction.

15. The IC package according to claim 14, wherein the further component is one of a package substrate, an interposer, or a further IC die.
